# EUROPEAN PATENT SPECIFICATION

(11) **EP 2 493 070 B1**
(45) Date of publication and mention of the grant of the patent: **20.03.2019**
(21) Application number: 12275014.4
(22) Date of filing: 15.02.2012
(51) Int. Cl.: H03F 1/52, H03F 1/30, H03F 3/189, D03D 45/20

(54) **Voltage adaption unit and method of use thereof**
Spannungsanpassungseinheit und Anwendungsverfahren dafür
Unité d'adaptation de tension et son procédé d'utilisation

(30) Priority: 23.02.2011 GB 201103053
(43) Date of publication of application: 29.08.2012
(73) Proprietor: Radio Design Limited, Bradford, West Yorkshire BD17 7DW (GB)
(72) Inventor: Lucas, Casper, Bradford West Yorkshire BD17 7DW (GB); Hickling, Paul, Bradford West Yorkshire BD17 7DW (GB)
(74) Representative: Tomkinson, Alexandra

(56) References cited:
- WO-A1-2010/020984
- GB-A- 1 359 752
- GB-A- 2 425 443
- JP-A- H05 315 994
- US-A1- 2010 045 402
- US-A1- 2012 039 610
- Kathrein: "Kathrein WFS 28", Kathrein Catalogue 2011/12, 1 January 2011 (2011-01-01), XP055441450, Retrieved from the Internet: URL:xxx [retrieved on 2018-01-16]

## Description

This invention relates to a voltage adaption unit and method of use thereof.

Although the following description refers almost exclusively to a voltage adaption unit for location between a tower mounted amplifier and a base station for stepping down a voltage supplied via the base station to the amplifier, it will be appreciated by persons skilled in the art that the invention of the present invention could be used in any application where a change in voltage for an electrical appliance is required.

A tower mounted amplifier (TMA) is a low noise amplifier mounted adjacent an antenna on a mobile phone mast or base transceiver station. TMAs are provided in mobile networks to improve the signal to noise ratio of receive signals associated with the base transceiver station, thereby improving the sensitivity to signals received by the base station. A TMA will typically be powered by Direct Current (DC) voltage supplied from the base station along a co-axial feeder cable. The co-axial feeder cable also allows the passage of high frequency radio waves therealong between the base station and antenna mounted on the mobile mast.

It is important that the voltage supplied to the TMA does not exceed a pre-determined threshold limit, otherwise the TMA could receive too much voltage and become non-operational and/or damage components within the TMA. Different base stations vary in the voltage they output and so some base stations can provide a voltage in excess of the voltage requirement of one or more appliances mounted on the mast. It would be an expensive and time consuming process to replace the base stations and/or the appliances on the mast to ensure the correct voltage is supplied by the base station to a mast mounted appliance.

WO2010/020984 discloses a device and method for regulating voltage level in a telecommunications network. The device includes an input port for receiving RF telecommunication signals with input AC voltage from a network portion, isolating circuitry, which isolates input AC voltage, a transformer, which receives the AC voltage, relays, which provide selected voltage gain, thereby deriving regulated AC voltage.

Kathrein Catalogue 2011/12, XP055441450 - "Kathrein WFS 28" discloses a radio frequency unit having Direct Current (DC) voltage regulating means wherein user selection of 5V, 12V, 14V and 18V DC voltage passing through the unit can be made.

It is therefore an aim of the present invention to provide a voltage adaption or conversion unit that can be used with a TMA or other electrical appliance to overcome the abovementioned and/or similar problem.

It is a further aim of the present invention to provide a method of using a voltage adaption or conversion unit that overcomes the abovementioned problem.

According to a first aspect of the present invention there is provided a voltage adaption unit according to claim 1.

Thus, the present invention provides a voltage adaption unit that allows a DC voltage passing through said unit to be modified to a required value or value range, whilst allowing the passage of one or more radio frequency signals or alternating current (AC) through the unit.

Preferably the voltage adaption unit includes at least two transmission pathways; a first transmission pathway for the transmission of one or more radio frequency signals or AC voltage but the substantial or significant exclusion (and preferably total exclusion) of DC voltage, and at least a second transmission pathway for the transmission of DC voltage but the substantial or significant exclusion (or at least significant reduction) of AC voltage or one or more radio frequency signals.

Preferably the unit includes a housing having the input connection and the output connection associated with the same. A cable, such as a feeder cable and/or coaxial cable, can be connected to the input connection and to the output connection of the unit.

Preferably the first and at least second transmission pathways are provided between the input connection and the output connection of the unit. The first and at least second transmission pathways share a common pathway adjacent said input connection and said output connection.

The radio frequency transmission means is provided between the input connection and the output connection of the unit. The radio frequency transmission means can be any or any combination of one or more radio frequency transmission lines, cables, suitable circuitry and/or the like.

The DC voltage blocking means is to prevent transmission of low frequency or DC voltage therealong but which allows AC voltage or one or more radio frequency signals through the same. The DC voltage blocking means associated with the radio transmission means can include any or any combination of a gap in the radio frequency transmission line, one or more pins with a gap between the same, one or more inductors, capacitors and/or the like.

The DC voltage regulating means can include any means that allows regulation of DC voltage passing therethrough. This regulation is preferably a step down in DC voltage but could include a step up in DC voltage if required. The voltage is typically regulated to a pre-determined value or range chosen by the manufacturer and/or the user. In one example, the DC voltage regulating means is a voltage regulator of a type supplied by Texas Instruments, Inc.

The radio frequency blocking means in one example is an AC voltage blocking means. It prevents or at least significantly reduces the transmission of AC voltage or high frequency radio waves therealong whilst allowing the passage of DC voltage. The radio frequency blocking means associated with the DC voltage regulating means can include an AC voltage blocking means, one or more inductors, capacitors and/or the like.

The radio frequency blocking means is typically provided before and after the DC voltage regulating means. For example, one radio frequency blocking means is provided in the second transmission pathway between the input connection of the unit and the DC voltage regulating means and a second radio frequency blocking means is provided in the second transmission pathway between the DC voltage regulating means and the output connection of the unit.

In one embodiment lightning strike protection means are associated with the DC voltage regulating means. Preferably the lightning strike protection means are located after the DC voltage regulating means in the circuitry of the unit (i.e. the lightning strike protection means are preferably provided between the output connection of the unit and the DC voltage regulating means and further preferably in the second transmission pathway).

The lightning strike protection means can include a gas discharge tube or means and/or the like.

In one embodiment voltage and current overprotection means are provided and/or are associated with the DC voltage regulating means. The voltage and current overprotection means ensures the voltage adaption unit shuts down in the event there is a problem with the electrical appliance the voltage adaption unit is to be used with (i.e. an item of electrical appliance located upstream of the voltage adaption unit in use). This ensures the voltage adaption unit is robust and increases the working life expectancy of the same. In addition, the voltage and current overprotection means shuts the unit down in the event the DC voltage regulating means becomes too hot.

The voltage and current overprotection means typically provides "conditioning" of the voltage passing between the input connection and the output connection of the unit. This reduces or eliminates unwanted transients at the input connection and/or output connection of the unit that can be present during an initial start up of the system in which the voltage adaption unit is used. The unwanted transients typically include current surges which are reduced to a pre-determined limit in terms of time and magnitude. This is typically achieved in one embodiment using any or any combination of one or more capacitors, inductors, transistors and/or the like.

The unit housing can be of any suitable, size, shape and/or design to provide protection for the circuitry located therein. It can be formed from any or any combination of suitable materials, such as metal, plastic and/or the like. In a preferred embodiment the unit housing is formed from aluminium. Preferably sealing means are associated with the housing to allowing sealing of the same. This prevents moisture, dirt, debris and/or the like from entering the unit in use, particularly if the unit is used in an outdoor location. In one example, the sealing means includes one or more gaskets, such as silicon gaskets and/or the like.

The voltage adaption unit of the present invention is typically fitted "in-line" between two cables due to the low radio frequency signal loss, such as co-axial feeder cables and/or the like. The unit can be fitted at any point between a voltage supply and an item of electrical appliance for which the voltage needs to be converted to a different value to that of the voltage supply.

In a preferred embodiment the voltage adaption unit is located between a base transceiver station in a mobile network and a mobile tower or mast mounted electrical appliance, such as a tower mounted amplifier, antenna motor and/or the like. The resulting unit typically generates no or low levels of unwanted inter-modulation interference signals. It has the advantage that the electrical appliance, antenna, tower mounted amplifier and/or base station does not have to be replaced whilst allowing compatibility between the different components within the mobile network.

In a preferred embodiment the input voltage to the voltage adaption unit can range from approximately 17-30 volts and the output voltage is approximately 12 volts. Thus, the DC voltage regulating means can step down the voltage by up to approximately 18 volts.

According to a second aspect of the present invention there is provided a method of using a voltage adaption unit according to claim 14.

Embodiments of the present invention will now be described with reference to the accompanying figures, wherein:

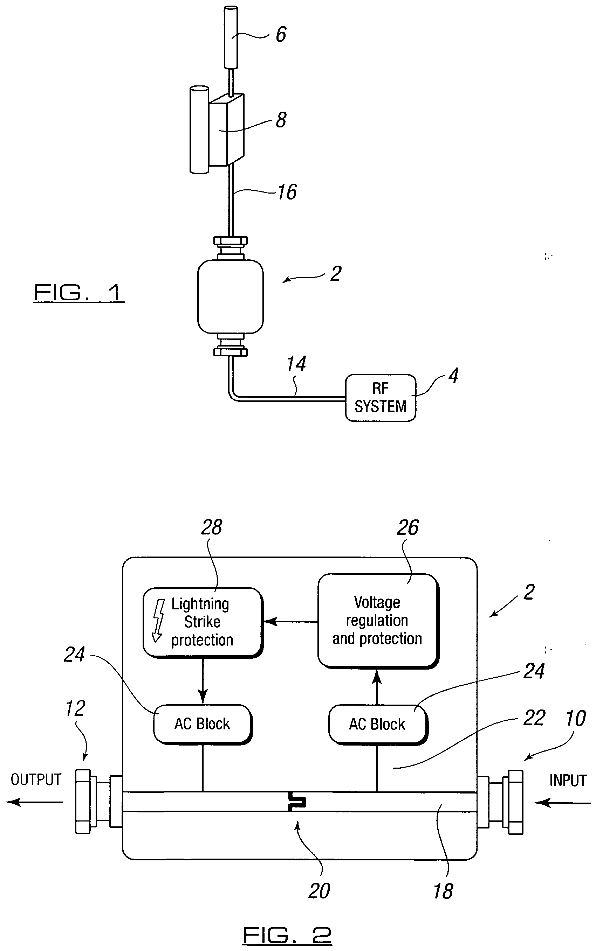

Figure 1 is a simplified view of a voltage adaption unit in a mobile network according to one embodiment of the present invention;
Figure 2 is a simplified view showing the components of a voltage adaption unit according to an embodiment of the present invention; and

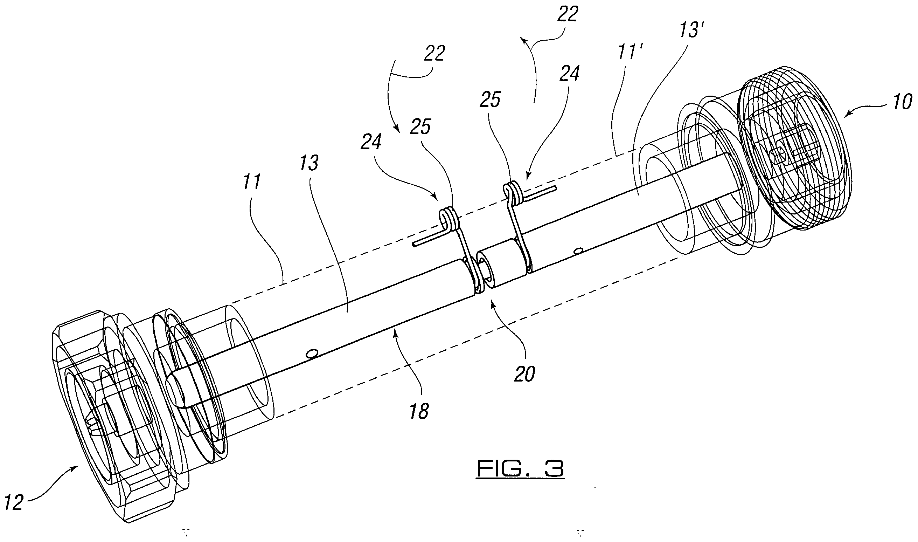

Figure 3 is a partial view taken through a voltage adaption unit in one embodiment showing the AC voltage or radio frequency blocking means and the DC voltage blocking means.

Referring to the figures, there is provided a voltage adaption unit 2 located between a radio frequency base station 4 and a tower mounted electrical appliance of a mobile network. The tower mounted electrical appliance is located adjacent an antenna 6 and, in this example, is a TMA 8.

The voltage adaption unit 2 has an input connection 10 and an output connection 12. A co-axial feeder cable 14, 16 is provided between the base station 4 and input connection 10, and the output connection 12 and TMA 8, respectively.

The voltage adaption unit 2 in this example ensures the voltage being supplied from base station 4 is stepped down before reaching TMA 8 so as to prevent excess voltage from damaging the TMA.

A radio frequency transmission line 18 is provided between the input connection 10 and output connection 12 of unit 2 to allow the transmission of radio frequency signals therealong. This typically defines a first transmission pathway. More particularly, in this example, the transmission line includes an outer casing 11, 11' and inner pins 13, 13'.

DC voltage blocking means 20 are provided on the transmission line 18 between the input and output connections 10, 12 to prevent DC voltage from travelling along transmission line 18 between the input and output connections 10, 12.

In the illustrated example, the pin 13 has a reduced diameter adjacent DC voltage blocking means 20 for location in a channel (not shown) defined in pin 13' adjacent blocking means 20. A gap is formed between the pins 13, 13', which is typically filled by a plastic cylindrical member to prevent the ends of the pins 13, 13' from touching each other. This acts as a total block to DC voltage but which allows the passage of radio frequency signals along transmission line 18.

A DC voltage or second transmission pathway 22 is defined off of transmission line 18, and DC voltage prevented from travelling along line 18 by blocking means 20 is diverted along pathway 22. More specifically, pathway 22 splits off from transmission line 18 before DC voltage blocking means 20 (i.e. between input connection 10 and DC voltage blocking means 20) and rejoins transmission line 18 after the DC voltage blocking means 20 (i.e. between output connection 12 and DC voltage blocking means 20).

In the illustrated example, AC voltage or radio frequency blocking means 24 are provided at the start and end of the second transmission pathway 22 so as to prevent, or at least substantially attenuate, the transmission of radio frequency signals or AC voltage along pathway 22 and to ensure radio frequency signals and AC voltage travels along pathway 18. Inductors 25 form the blocking means 24 in this particular illustration, although it will be appreciated by persons skilled in the art that there are a number of different methods for substantially attenuating the radio frequency signals or AC voltage along pathway 22.

A voltage regulator 26 is provided between the two blocking means 24 to regulate or step down the voltage travelling along pathway 22 to a required value necessary for optimal working of TMA 8. Lighting strike protection means 28 are provided between the voltage regulator 26 and the blocking means 24 closest to output connection 12 to prevent lighting from travelling down the mast and damaging the voltage regulator 26.

Unit 2 comprises a two part housing that is sealingly engaged together when assembled. Sealing gaskets are provided at the input and output connections to seal the unit from moisture, dirt and/or the like.

Thus, it can be seen that the voltage adaption unit of the present invention is a simple and cost effective unit that can allow a step down of the supply voltage to a TMA to prevent damage to the TMA caused by excess voltage.

## Claims

1. A voltage adaption unit (2), said voltage adaption unit (2) including Direct Current (DC) voltage regulating means (26) for allowing regulation of DC voltage passing through said unit, radio frequency blocking means (24) associated with an input and an output of said DC voltage regulating means (26) to prevent or significantly reduce one or more radio frequency signals from passing through said DC voltage regulating means, radio frequency transmission means (18) for allowing one or more radio frequency signals to pass through said unit and DC voltage blocking means (20) associated with the radio frequency transmission means (18) for substantially preventing DC voltage from passing along said radio frequency transmission means (18); **characterised in that** the unit (2) has an input connection (10) and an output connection (12), and both the one or more radio frequency signals and the DC voltage are arranged to pass through the input connection (10) and the output connection (12) in use.

2. A voltage adaption unit according to claim 1 wherein the voltage adaption unit (2) includes at least two transmission pathways; a first transmission pathway (18) for the transmission of one or more radio frequency signals or Alternating Current (AC) voltage but the substantial or significant exclusion of DC voltage, and at least a second transmission pathway (22) for the transmission of DC voltage but the substantial or significant exclusion of AC voltage or one or more radio frequency signals.

3. A voltage adaption unit according to claim 1 wherein a cable, feeder cable and/or co-axial cable (14, 16) is connected to the input connection (10) and to the output connection (12).

4. A voltage adaption unit according to claim 2 wherein the first and at least second transmission pathways (18, 22) are provided between the input connection (10) and the output connection (12) of the unit (2), the first and at least second transmission pathways (18, 22) sharing a common pathway adjacent said input connection (10) and said output connection (12).

5. A voltage adaption unit according to claim 1 wherein the DC voltage blocking means (20) associated with the radio frequency transmission means (18) includes any or any combination of a gap in the radio frequency transmission line, one or more pins (13, 13') with a gap between the same, one or more inductors or capacitors.

6. A voltage adaption unit according to claim 1 wherein the DC voltage regulating means (26) steps down the DC voltage passing through the unit (2) or steps up the DC voltage passing through the unit (2).

7. A voltage adaption unit according to claim 1 wherein the radio frequency blocking means (24) is an Alternating Current (AC) blocking means and/or includes one or more inductors (25) and/or capacitors.

8. A voltage adaption unit according to claim 1 wherein lightning strike protection means (28) are associated with or provided after the DC voltage regulating means (26) in a transmission pathway (22).

9. A voltage adaption unit according to claim 8 wherein the lightning strike protection means (28) include a gas discharge tube or means.

10. A voltage adaption unit according to claim 1 wherein voltage and current overprotection means are provided and/or are associated with the DC voltage regulating means.

11. A voltage adaption unit according to claim 10 wherein the voltage and current overprotection means includes any or any combination of one or more capacitors, transistors and/or inductors.

12. A voltage adaption unit according to claim 1 wherein an input voltage to the voltage adaption unit (2) is between approximately 17-30 volts and an output voltage is approximately 18 volts.

13. A voltage adaption unit according to claim 1 connected between a base transceiver station (4) in a mobile network and a mobile tower, mast mounted electrical appliance, tower mounted amplifier (8) and/or antenna motor.

14. A method of using a voltage adaption unit, said method including the steps of passing voltage through said voltage adaption unit (2) so that said Direct Current (DC) voltage passes through DC voltage regulating means (26) for regulating said DC voltage whilst preventing or significantly reducing one or more radio frequency signals from passing through said DC voltage regulating means (26) using radio frequency blocking means (24) associated with an input and an output of said DC voltage regulating means (26), passing one or more radio frequency signals through said unit (2) along radio frequency transmission means (18) whilst substantially preventing DC voltage from passing along said radio frequency transmission means (18) using DC blocking means (20), **characterised in that** the unit (2) has an input connection (10) and an output connection (12), and both the one or more radio frequency signals and the DC voltage pass through the input connection (10) and the output connection (12).

## Patentansprüche

1. Spannungsanpassungseinheit (2), wobei die genannte Spannungsanpassungseinheit (2) ein Gleich- (Direct Current, DC) - spannungsregulierungsmittel (26) zum Ermöglichen der Regulierung von durch die genannte Einheit hindurchgeleiteter Gleichspannung, ein Hochfrequenzblockiermittel (24), das einem Eingang und einem Ausgang des genannten Gleichspannungsregulierungsmittels (26) zugeordnet ist, um ein oder mehr Hochfrequenzsignale am Durchgang durch das genannte Gleichspannungsregulierungsmittel zu hindern oder beträchtlich zu reduzieren, ein Hochfrequenzdurchlassmittel (18) zum Ermöglichen des Durchgangs von einem oder mehr Hochfrequenzsignalen durch die genannte Einheit und ein Gleichspannungsblockiermittel (20), das dem Hochfrequenzdurchlassmittel (18) zugeordnet ist, um Gleichspannung im Wesentlichen am Durchgang entlang des genannten Hochfrequenzdurchlassmittels (18) zu hindern; **dadurch gekennzeichnet, dass** die Einheit (2) einen Eingangsanschluss (10) und einen Ausgangsanschluss (12) hat und sowohl die ein oder mehr Hochfrequenzsignale als auch die Gleichspannung für Durchgang durch den Eingangsanschluss (10) und den Ausgangsanschluss (12) im Gebrauch angeordnet sind.

2. Spannungsanpassungseinheit nach Anspruch 1, wobei die Spannungsanpassungseinheit (2) wenigstens zwei Durchlassleitbahnen beinhaltet: eine erste Durchlassleitbahn (18) für den Durchgang von einem oder mehr Hochfrequenzsignalen oder Wechsel- (Alternating Current, AC) -spannung, aber den wesentlichen oder bedeutenden Ausschluss von Gleichspannung, und wenigstens eine zweite Durchlassleitbahn (22) für den Durchgang von Gleichspannung, aber den wesentlichen oder bedeutenden Ausschluss von Wechselspannung oder von ein oder mehr Hochfrequenzsignalen.

3. Spannungsanpassungseinheit nach Anspruch 1, wobei mit dem Eingangsanschluss (10) und dem Ausgangsanschluss (12) ein Kabel, Anschlusskabel und/oder Koaxialkabel (14, 16) verbunden ist.

4. Spannungsanpassungseinheit nach Anspruch 2, wobei die erste und wenigstens zweite Durchlassleitbahn (18, 22) zwischen dem Eingangsanschluss (10) und dem Ausgangsanschluss (12) der Einheit (2) bereitgestellt sind, wobei die erste und wenigstens zweite Durchlassleitbahn (18, 22) sich eine an den genannten Eingangsanschluss (10) und den genannten Ausgangsanschluss (12) angrenzende gemeinsame Leitbahn teilen.

5. Spannungsanpassungseinheit nach Anspruch 1, wobei das dem Hochfrequenzdurchlassmittel (18) zugeordnete Gleichspannungsblockiermittel (20) eines oder eine Kombination von Folgenden aufweist: einen Spalt in der Hochfrequenzdurchlassleitung, ein oder mehr Stifte (13, 13') mit einem Spalt zwischen denselben, ein(e) oder mehr Spulen oder Kondensatoren.

6. Spannungsanpassungseinheit nach Anspruch 1, wobei das Gleichspannungsregulierungsmittel (26) die durch die Einheit (2) durchgehende Gleichspannung erniedrigt oder die durch die Einheit (2) durchgehende Gleichspannung erhöht.

7. Spannungsanpassungseinheit nach Anspruch 1, wobei das Hochfrequenzblockiermittel (24) ein Wechselstrom- (Alternating Current, AC) - blockiermittel ist und/oder ein(e) oder mehr Spulen (25) und/oder Kondensatoren aufweist.

8. Spannungsanpassungseinheit nach Anspruch 1, wobei Blitzschutzmittel (28) mit dem oder nach dem Gleichspannungsregulierungsmittel (26) in einer Durchlassleitbahn (22) zugeordnet oder bereitgestellt sind.

9. Spannungsanpassungseinheit nach Anspruch 8, wobei die Blitzschutzmittel (28) ein(e) Gasentladungsröhre oder -mittel aufweisen.

10. Spannungsanpassungseinheit nach Anspruch 1, wobei Überspannungs- und Überstromschutzmittel bereitgestellt sind und/oder dem Gleichspannungsregulierungsmittel zugeordnet sind.

11. Spannungsanpassungseinheit nach Anspruch 10, wobei das Überspannungs- und Überstromschutzmittel eine(n) oder eine Kombination von einem oder mehr Kondensatoren, Transistoren und/oder Spulen aufweist.

12. Spannungsanpassungseinheit nach Anspruch 1, wobei eine Eingangsspannung zur Spannungsanpassungseinheit (2) zwischen etwa 17 - 30 Volt ist und eine Ausgangsspannung etwa 18 Volt ist.

13. Spannungsanpassungseinheit nach Anspruch 1, die zwischen eine Funkbasisstation (4) in einem Mobilfunknetzwerk und einen Mobilfunkturm, ein an einem Mast montiertes elektrisches Gerät, einen an einem Turm montierten Verstärker (8) und/oder einen Antennenmotor geschaltet ist.

14. Verfahren zum Verwenden einer Spannungsanpassungseinheit, wobei das genannte Verfahren die folgenden Schritte aufweist: Durchleiten von Spannung durch die genannte Spannungsanpassungseinheit (2), so dass die genannte Gleich- (Direct Current, DC) -spannung durch ein Gleichspannungsregulierungsmittel (26) zum Regulieren der genannten Gleichspannung hindurchgeht, während ein oder mehr Hochfrequenzsignale unter Verwendung eines Hochfrequenzblockiermittels (24), das einem Eingang und einem Ausgang des genannten Gleichspannungsregulierungsmittels (26) zugeordnet ist, am Durchgang durch das genannte Gleichspannungsregulierungsmittel (26) gehindert oder wesentlich reduziert werden, Durchleiten von einem oder mehr Hochfrequenzsignalen durch die genannte Einheit (2) entlang eines Hochfrequenzdurchlassmittels (18), während Gleichspannung unter Verwendung eines DC-Blockiermittels (20) im Wesentlichen am Durchgang entlang des genannten Hochfrequenzdurchlassmittels (18) gehindert wird; **dadurch gekennzeichnet, dass** die Einheit (2) einen Eingangsanschluss (10) und einen Ausgangsanschluss (12) hat und sowohl die ein oder mehr Hochfrequenzsignale als auch die Gleichspannung durch den Eingangsanschluss (10) und den Ausgangsanschluss (12) hindurchgeleitet werden.

## Revendications

1. Unité d'adaptation de tension (2), ladite unité d'adaptation de tension (2) incluant un moyen de régulation de tension de courant continu (CC) (26) pour permettre la régulation d'une tension CC passant à travers ladite unité, un moyen de blocage de radiofréquence (24) associé à une entrée et une sortie dudit moyen de régulation de tension CC (26) pour empêcher, ou réduire significativement, le passage d'un ou de plusieurs signaux de radiofréquence à travers ledit moyen de régulation de tension CC, un moyen de transmission en radiofréquence (18) pour permettre à un ou plusieurs signaux de radiofréquence de passer à travers ladite unité et un moyen de blocage de tension CC (20) associé au moyen de transmission en radiofréquence (18) pour empêcher substantiellement la tension CC de passer le long dudit moyen de transmission CC (18) ; **caractérisée en ce que** l'unité (2) possède une connexion d'entrée (10) et une connexion de sortie (12), et à la fois lesdits un ou plusieurs signaux de radiofréquence et la tension CC sont agencés de façon à passer à travers la connexion d'entrée (10) et la connexion de sortie (12) lors de l'utilisation.

2. Unité d'adaptation de tension selon la revendication 1, dans laquelle l'unité d'adaptation de tension (2) inclut au moins deux trajets de transmission ; un premier trajet de transmission (18) pour la transmission d'un ou de plusieurs signaux de radiofréquence ou d'une tension de courant alternatif (CA) mais à l'exclusion substantielle ou significative d'une tension CC, et au moins un deuxième trajet de transmission (22) pour la transmission d'une tension CC mais à l'exclusion substantielle ou significative d'une tension CA ou d'un ou de plusieurs signaux de radiofréquence.

3. Unité d'adaptation de tension selon la revendication 1, dans laquelle un câble, un câble d'alimentation et/ou un câble coaxial (14, 16) est connecté à la connexion d'entrée (10) et à la connexion de sortie (12).

4. Unité d'adaptation de tension selon la revendication 2, dans laquelle les premier et au moins deuxième trajets de transmission (18, 22) sont prévus entre la connexion d'entrée (10) et la connexion de sortie (12) de l'unité (2), les premier et au moins deuxième trajets de transmission (18, 22) partageant un trajet commun adjacent à ladite connexion d'entrée (10) et ladite connexion de sortie (12).

5. Unité d'adaptation de tension selon la revendication 1, dans laquelle le moyen de blocage de tension CC (20) associé au moyen de transmission en radiofréquence (18) inclut n'importe lequel ou n'importe quelle combinaison des éléments parmi un espacement dans la ligne de transmission en radiofréquence, une ou plusieurs broches (13, 13') avec un espacement entre celles-ci, un(e) ou plusieurs condensateurs ou bobines d'induction.

6. Unité d'adaptation de tension selon la revendication 1, dans laquelle le moyen de régulation de tension CC (26) abaisse la tension CC passant à travers l'unité (2) ou élève la tension CC passant à travers l'unité (2).

7. Unité d'adaptation de tension selon la revendication 1, dans laquelle le moyen de blocage de radiofréquence (24) est un moyen de blocage de courant alternatif (CA) et/ou inclut un(e) ou plusieurs bobines d'induction (25) et/ou condensateurs.

8. Unité d'adaptation de tension selon la revendication 1, dans laquelle les moyens de protection parafoudre (28) sont associés à ou sont prévus après le moyen de régulation de tension CC (26) dans un trajet de transmission (22).

9. Unité d'adaptation de tension selon la revendication 8, dans laquelle les moyens de protection parafoudre (28) incluent un moyen ou un tube à décharge de gaz.

10. Unité d'adaptation de tension selon la revendication 1, dans laquelle des moyens de surprotection de courant et de tension sont prévus et/ou sont associés au moyen de régulation de tension CC.

11. Unité d'adaptation de tension selon la revendication 10, dans laquelle le moyen de surprotection de courant et de tension inclut n'importe lequel ou n'importe quelle combinaison des postes parmi des condensateurs, des transistors et/ou des bobines d'induction.

12. Unité d'adaptation de tension selon la revendication 1, dans laquelle une tension d'entrée au niveau de l'unité d'adaptation de tension (2) se situe entre environ 17 et 30 volts et une tension de sortie est environ de 18 volts.

13. Unité d'adaptation de tension selon la revendication 1, connectée entre une station émettrice-réceptrice de base (4) dans un réseau mobile et une tour mobile, un appareil électrique monté sur pylône, un amplificateur monté sur tour (8) et/ou un moteur d'antenne.

14. Procédé d'utilisation d'une unité d'adaptation de tension, ledit procédé incluant les étapes consistant à faire passer une tension à travers ladite unité d'adaptation de tension (2) de sorte que ladite tension de courant continu (CC) passe à travers le moyen de régulation de tension CC (26) pour réguler ladite tension CC tout en empêchant, ou en réduisant significativement, le passage d'un ou de plusieurs signaux de radiofréquence à travers ledit moyen de régulation de tension CC (26) grâce à l'utilisation d'un moyen de blocage de radiofréquence (24) associé à une entrée et une sortie dudit moyen de régulation de tension CC (26), faire passer un ou plusieurs signaux de radiofréquence à travers ladite unité (2) le long du moyen de transmission en radiofréquence (18) tout en empêchant substantiellement la tension CC de passer le long dudit moyen de transmission en radiofréquence (18) grâce à l'utilisation du moyen de blocage CC (20), **caractérisé en ce que** l'unité (2) possède une connexion d'entrée (10) et une connexion de sortie (12), et à la fois lesdits un ou plusieurs signaux de radiofréquence et la tension CC passent à travers la connexion d'entrée (10) et la connexion de sortie (12).
